# EUROPEAN PATENT APPLICATION

(11) **EP 3 518 375 A1**
(43) Date of publication of application: **31.07.2019**
(21) Application number: 17853036.6
(22) Date of filing: 19.09.2017
(51) Int. Cl.: H02J 7/00, H01M 10/42, H01M 10/48

(54) **BATTERY SYSTEM**

(30) Priority: 21.09.2016 JP 2016183989; 27.04.2017 JP 2017088108
(71) Applicant: Envision AESC Japan Ltd., Zama-shi, Kanagawa 252-0012 (JP)
(72) Inventor: KANEKO Kazumi, Zama-shi Kanagawa 252-0012 (JP)
(74) Representative: Herzog, Fiesser & Partner Patentanwälte PartG mbB
(86) International application number: PCT/JP2017/033733
(87) International publication number: WO 2018/056264

(57) **Abstract**

Provided is a battery system having high expandability. Each battery pack included in a battery system (1) acquires physical quantities of one or more batteries. Battery state information is calculated based on the acquired physical quantities. Then, each battery pack communicates with another battery pack. One battery pack is set as a master battery pack MP. Another battery pack other than the master battery pack (MP) is set as a slave battery pack (SP). The slave battery pack (SP) transmits the battery state information to the master battery pack (MP). The master battery pack (MP) calculates integrated battery information based on the battery state information of each battery pack.

## Description

### TECHNICAL FIELD

The present invention relates to a battery system.

### BACKGROUND ART

In recent years, electric vehicles running by electric motors and hybrid vehicles having internal combustion engines and electric motors as power sources have been widely used. A chargeable and dischargeable battery pack for storing electric power for driving an electric motor is mounted on a vehicle (hereinafter referred to as "electric vehicle") such as the electric vehicle and the hybrid vehicle using the electric motor for driving the vehicle. A plurality of battery packs is connected in parallel to a load in order to secure battery capacity corresponding to the electric vehicle. When it is desired to further increase the battery capacity, additional battery packs are connected in parallel (hereinafter referred to as "parallel expansion").

In the electric vehicle, it is known to provide a system controller which controls the whole of a plurality of battery packs outside the plurality of battery packs in order to monitor and control a state of each of the plurality of battery packs (for example, PATENT LITERATURE 1). In PATENT LITERATURE 1, a battery unit as the battery pack has a battery controller. Each battery controller and system controller communicate with each other by a polling method. Specifically, the system controller requests the battery controller to transmit control information such as voltage, current, and temperature of the battery. In response to the request, the battery controller transmits the control information to the system controller. The system controller receives the control information from each battery controller. Then, state information such as SOC (State Of Charge) of each battery unit is calculated.

Further, the system controller which controls the whole of the plurality of battery packs may calculate integrated battery information by performing a predetermined process such as a statistical process of the state information (SOC and the like) of each battery unit. Such integrated battery information is transmitted to a higher-level system (for example, a vehicle control unit or the like).

### CITATION LIST

### PATENT LITERATURE

PATENT LITERATURE 1: JP-A-2010-207029

### SUMMARY OF THE INVENTION

### PROBLEMS TO BE SOLVED BY THE INVENTION

The above-described typical battery system has the following problems.
When the number of battery packs (that is, the number of battery controllers) communicating with the system controller increases due to parallel expansion or the like, a communication volume from the battery controller for the system controller to calculate the state information of each battery pack increases. This increase in the communication volume can be an obstacle in constructing a highly expandable battery system.

Accordingly, an object of the present invention is to provide a battery system having higher expandability than before.

### SOLUTION TO THE PROBLEMS

A battery system according to an embodiment of the present invention includes a plurality of battery packs, wherein each of the plurality of battery packs comprises: one or a plurality of batteries; an acquiring unit that acquires physical quantities of the one or the plurality of batteries; a calculation unit that calculates battery state information which is information on a state of the one or the plurality of batteries based on the acquired physical quantities; and a communication unit that communicates with another battery pack, any battery pack of the plurality of battery packs is set as a master battery pack and a battery pack other than the master battery pack is set as a slave battery pack, and the slave battery pack transmits the calculated battery state information to the master battery pack, and the master battery pack calculates integrated battery information which is integrated information of the plurality of battery packs based on each battery state information of the plurality of battery packs.

### EFFECTS OF THE INVENTION

According to the battery system of the present invention, its expandability is improved more than before.

### BRIEF DESCRIPTION OF THE DRAWINGS

Fig. 1 is a schematic circuit diagram of a battery system according to an embodiment.
Fig. 2 is a schematic circuit diagram of a slave battery pack according to the embodiment.
Fig. 3 is a schematic circuit diagram of a master battery pack according to the embodiment.
Fig. 4 is a flowchart showing a process of the slave battery pack according to the embodiment.
Fig. 5 is a flowchart showing a process of the master battery pack according to the embodiment.
Fig. 6 is a timing chart of a main process in the battery system according to the embodiment.

### DESCRIPTION OF THE EMBODIMENTS

Hereinafter, a battery system 1 according to one embodiment of the present invention will be described. The battery system 1 of the present embodiment includes a plurality of battery packs serving as a power source of an electric motor mounted on an electric vehicle.

### (1) Overall configuration of battery system 1

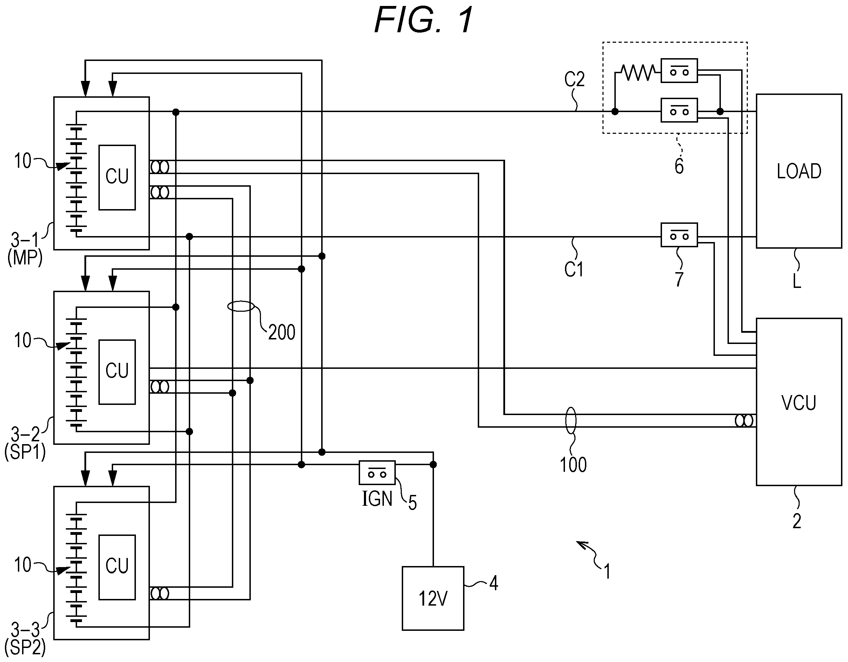

First, overall configuration of the battery system 1 of the present embodiment will be described with reference to Fig.1. Fig. 1 is a schematic circuit diagram of the battery system 1 according to the embodiment. As shown in Fig. 1, a plurality of battery packs 3-1 to 3-3 are connected in parallel to a load L in the battery system 1 in order to secure a predetermined battery capacity. In the battery system 1 shown in Fig. 1, three battery packs are connected to the load L for simplicity of explanation. However, the number of connected battery packs may be two or four or more.

The load L is, for example, a power conversion device such as an inverter. The inverter converts a DC voltage of each battery pack into an AC voltage and supplies power to an AC motor (for example, a three-phase AC motor) used for driving the vehicle. When the AC motor regenerates, the inverter supplies power generated by the AC motor to each battery pack. When the electric vehicle is decelerated, each battery pack is charged by regenerative power of the AC motor.

In the electric vehicle, a charging device for charging the plurality of battery packs or a DC/DC converter or the like for boosting or reducing the DC voltage of the plurality of battery packs to a predetermined DC voltage may be connected to the plurality of battery packs as required. The charging device or the DC/DC converter may be mounted on the electric vehicle or may be outside the electric vehicle.

Each battery pack accommodates a battery module including a plurality of stacked battery cells. Each battery pack is not limited to a case where a plurality of battery cells is included, but may include only a single battery cell.

In the battery system 1 of the present embodiment, any one of the plurality of battery packs is set as a master battery pack MP which is a battery pack serving as a master. Then, the battery pack other than the master battery pack MP is set as a slave battery pack SP serving as the slave. Among the plurality of battery packs, the master battery pack MP is the battery pack which communicates with a vehicle control unit (VCU: Vehicle Control Unit) 2. In an example shown in Fig. 1, the battery pack 3-1 is set as the master battery pack MP. Then, the battery packs 3-2 and 3-3 are set as the slave battery packs SP.

In the following description of items common to the slave battery packs SP1 and SP2, these slave battery packs are collectively referred to as the slave battery packs SP.

In the battery system 1 of the present embodiment, main relays 6 and 7 are respectively arranged on a high-pressure side line C2 and a low-pressure side line C1 connected to the load L, and are controlled by the vehicle control unit 2. For example, the vehicle control unit 2 turns on or off the main relays 6 and 7 in conjunction with an ignition switch 5. That is, the main relays 6 and 7 are closed or opened in conjunction with turning on or off of the ignition switch 5. Thus, the voltage of each battery pack is applied or not applied to the load L. In this way, a running state of the electric vehicle is controlled by the vehicle control unit 2.

As shown in Fig. 1, each of the plurality of battery packs 3-1 to 3-3 includes a control unit (CU: Control Unit). A 12 V battery 4 of the electric vehicle is connected to each battery pack. Then, the control unit in each battery pack operates by the 12 V battery 4. The 12 V battery 4 is, for example, a lead-acid battery.

The electric vehicle of the present embodiment is provided with a vehicle system CAN bus 100 used for data communication between the vehicle control unit 2 and a main control unit (not shown) in the vehicle, and a battery system CAN bus 200 (local bus) used for data communication between the plurality of battery packs 3-1 to 3-3. As shown in Fig. 1, in the battery system 1 of the present embodiment, only the master battery pack MP among the plurality of battery packs communicates with the vehicle control unit 2 via the vehicle system CAN bus 100.

A data frame to be transmitted to the CAN (Controller Area Network) bus includes a data field containing data contents and an ID for identifying a transmitting node (any one of the battery packs 3-1 to 3-3 and the vehicle control unit 2 in the present embodiment). This ID is also used for communication mediation. That is, when the data frames are sent to the bus at the same time, a priority of the data sent to the bus is determined by a value of the ID. Thus, a data collision by different IDs is avoided.

In communication using the battery system CAN bus 200, the transmitting node transmits only the data frame to the CAN bus without using a remote frame. Then, the receiving node (any one of the battery packs 3-1 to 3-3 and the vehicle control unit 2 in the present embodiment) receives the data frame addressed to itself from the CAN bus based on the ID in the data frame. In short, the communication between the battery packs is performed by a producer-consumer method.

The communication between the master battery pack MP and the vehicle control unit 2 using the vehicle system CAN bus 100 may be performed by a polling method or by the producer-consumer manner.

### (2) Overall configuration of battery pack

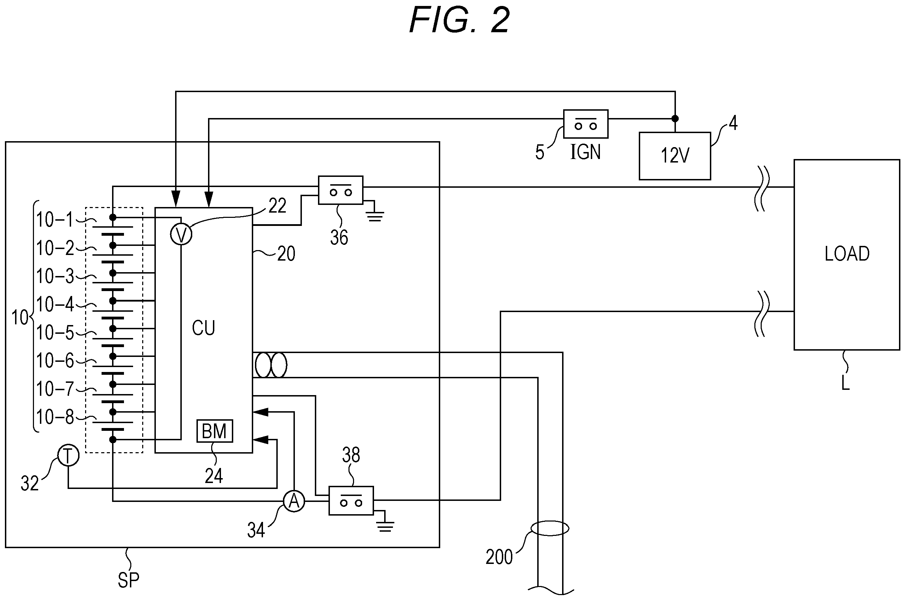

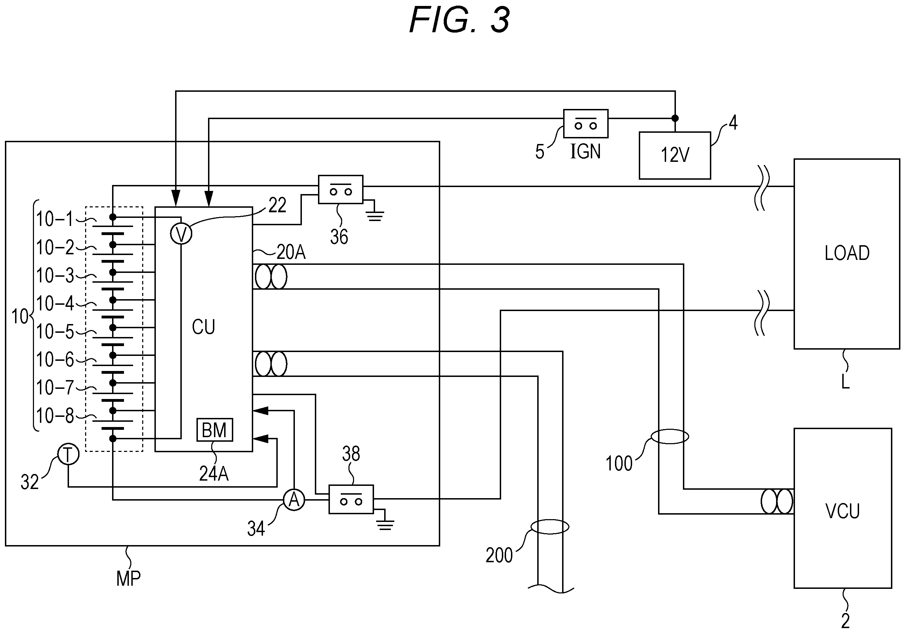

Next, a configuration of the battery pack included in the battery system 1 will be described with reference to Fig. 2 and Fig. 3. Fig. 2 is a schematic circuit diagram of the slave battery pack SP according to the present embodiment. Fig. 3 is a schematic circuit diagram of the master battery pack MP according to the present embodiment.

Referring to Fig. 2, the slave battery pack SP includes a battery module 10, a control unit 20, a voltage sensor 22, a temperature sensor 32, a current sensor 34, and relays 36 and 38.

The battery module 10 includes a plurality of battery cells 10-1 to 10-8 connected in series. Note that the connection of battery cells in the battery module 10 is not limited to a series connection. That is, a plurality of battery cells connected in parallel may be connected in series. Further, the battery cells connected in series can be connected in parallel, for example, by providing an interruption function between them. The control unit 20 is mainly includes a microcontroller and includes not only a voltage sensor 22 and a buffer memory 24 as shown but also a CAN transceiver (not shown) and a relay drive circuit (not shown) for driving the relays 36 and 38.

The voltage sensor 22 is built in the control unit 20, and detects voltage between terminals of the battery module 10. The temperature sensor 32 is attached to the battery module 10 or disposed in the vicinity of the battery module 10, to detect a temperature of the battery module 10. The current sensor 34 is provided on a line connected to one end of the battery module 10, and detects an amount of current flowing through the line (that is, current flowing through the battery module 10).

The control unit 20 A/D-converts analog values of the voltage sensor 22, the current sensor 34, and the temperature sensor 32, and sequentially records digital values of voltage, current, and temperature in the buffer memory 24.

The control unit 20 reads the digital values of the voltage, the current, and the temperature recorded in the buffer memory 24 at a predetermined timing, to calculate battery state information (SOX) of the battery module 10. In a description of the present embodiment, examples of the battery state information SOX include an estimated value of any one of SOC, SOP (State Of Power), SOH (State Of Health), and an internal resistance of the battery module 10, and a combination of two or more estimated values. However, the battery state information SOX may be any other information as an index of a state of the battery.

The microcontroller of the control unit 20 controls the CAN transceiver, to transmit the data frame including the calculated battery state information SOX of the battery module 10 to the battery system CAN bus 200 at a preset timing (for example, at predetermined intervals). At this time, the data frame includes an ID for identifying the slave battery pack (that is, any one of the battery packs 3-2 and 3-3) which is the transmitting node. Here, timing setting information (such as a time value of the interval) is stored in a memory (not shown) in the control unit 20.

Referring to Fig. 3, the master battery pack MP includes the battery module 10, the voltage sensor 22, the temperature sensor 32, the current sensor 34, and relays 36 and 38 in the same manner as the slave battery pack SP in addition to the control unit 20A.

The control unit 20A mainly includes a microcontroller and includes not only the voltage sensor 22 and a buffer memory 24A as shown but also the CAN transceiver (not shown) and the relay drive circuit (not shown) for driving the relays 36 and 38.

A configuration of the control unit 20A of the master battery pack MP is substantially the same as that of the control unit 20 of the slave battery pack SP. However, the control unit 20A is different from the control unit 20 in the following points.

The control unit 20A controls the CAN transceiver to receive the state information of each battery module 10 of the slave battery packs SP1 and SP2 from the battery system CAN bus 200. The control unit 20A calculates integrated battery information based on the state information of the battery module 10 of the master battery pack MP and the received state information of each battery module 10 of the slave battery packs SP1 and SP2.
The integrated battery information is information obtained by integrating the battery state information SOX of each battery module 10 of the battery packs 3-1 to 3-3. The integrated battery information is information that is an overall index of battery characteristics of all the battery modules 10 included in the battery system 1. Examples of the integrated battery information include statistical information of the battery state information such as an average value of SOC of each battery module 10, information obtained by calculating mutual battery state information such as a sum of SOP of each battery module 10, and information relating to the minimum value of the battery state information such as a value obtained by multiplying the minimum value among the SOPs of the plurality of battery packs by the number of battery packs.

The control unit 20A transmits the data frame including the calculated integrated battery information to the vehicle system CAN bus 100 at a preset timing (for example, at predetermined intervals). At this time, the data frame includes an ID for identifying the master battery pack (that is, the battery pack 3-1) which is the transmitting node.

In the slave battery pack SP and the master battery pack MP described above, the voltage sensor 22, the temperature sensor 32, and the current sensor 34 are examples of acquiring devices, respectively. The control units 20 and 20A are examples of calculators and communication devices. The temperature of the battery module 10, the voltage between the terminals of the battery module 10, and the current flowing through the battery module 10 are examples of physical quantities of the battery module 10.

### (3) Operation of battery system 1

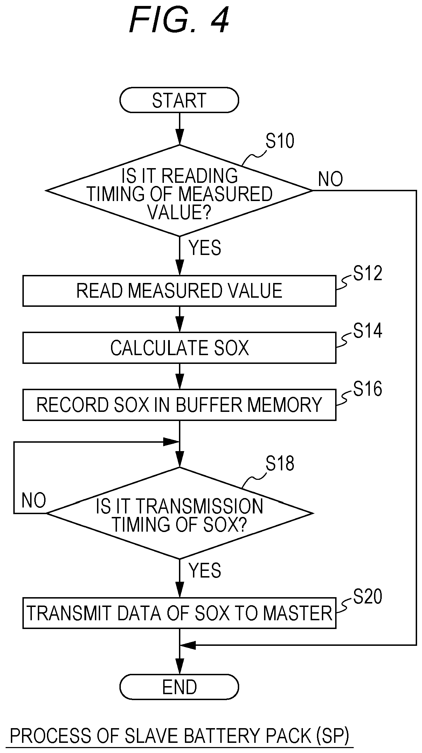

Next, an operation of the battery system 1 of the present embodiment will be described with reference to Figs. 4 to 6.

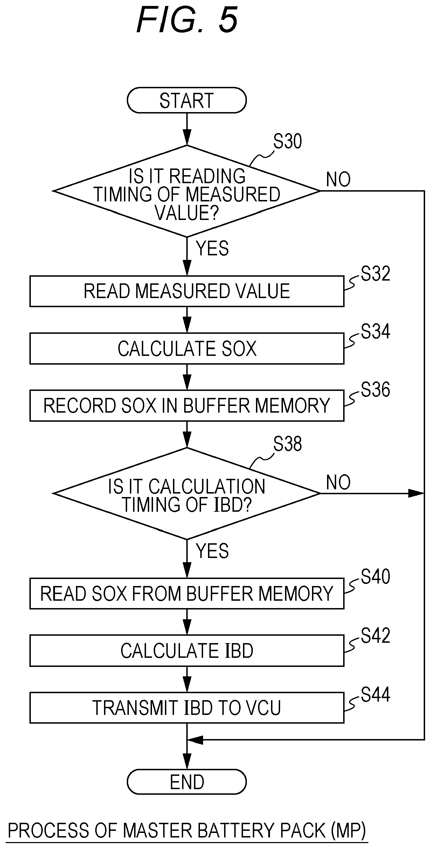

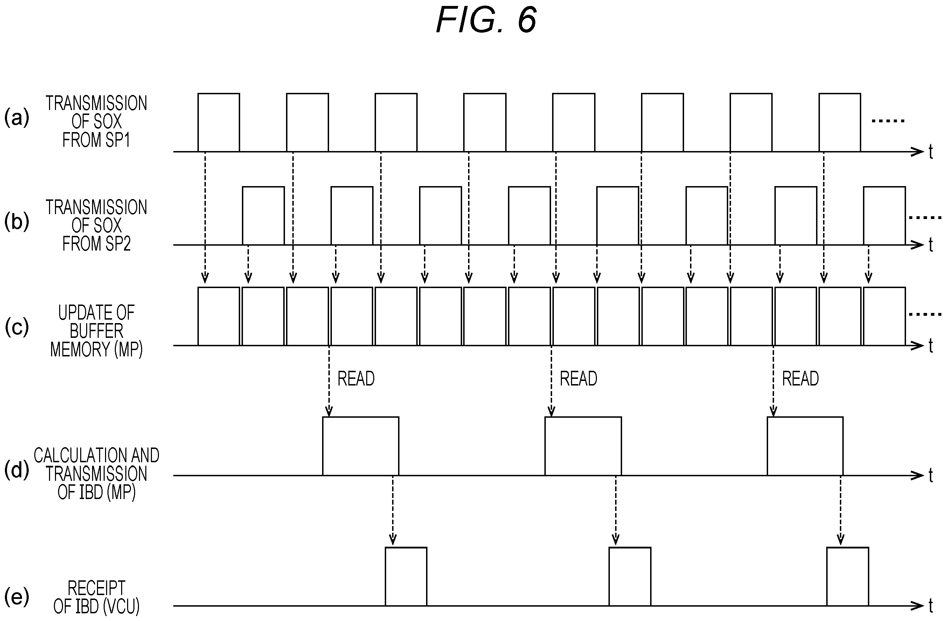

Fig. 4 is a flowchart showing a process of the slave battery pack SP according to the present embodiment. Fig. 5 is a flowchart showing a process of the master battery pack MP according to the present embodiment. Fig. 6 is a timing chart of a main process in the battery system 1 according to the present embodiment. The processes shown in Figs. 5 and 6 are mainly performed respectively by the microcontrollers of the control unit 20 of the slave battery pack SP and the control unit 20A of the master battery pack MP.

The control unit 20 of the slave battery pack SP A/D-converts the analog values of voltage, current, and temperature input from the voltage sensor 22, the current sensor 34, and the temperature sensor 32, and sequentially records the digital values (voltage data, current data, and temperature data) of the voltage, current, and temperature in the buffer memory 24. A sampling interval of detection values of each sensor is not limited, but is, for example, around 10 ms.

In Fig. 4, when the control unit 20 of the slave battery pack SP of the present embodiment has reached a reading timing of the voltage, current, and temperature of its own battery module 10 (Step S10: YES), the control unit 20 reads the voltage data, the current data, and the temperature data from the buffer memory 24 (Step S12). The reading timing is not limited, but is, for example, every 100 ms. Next, the control unit 20 calculates the battery state information SOX based on the read voltage data, current data, and temperature data (Step S14) and records it in the buffer memory 24 (Step S16).

Any known method can be adopted as a method of calculating the battery state information SOX of the battery module 10 based on the voltage data, the current data, and the temperature data. For example, the internal resistance of the battery module 10 may be calculated from the temperature data and the voltage data. The estimated value of SOC of the battery module 10 may be calculated, for example, by adding or subtracting a value obtained by multiplying the current data by the internal resistance to or from the voltage data. Further, it may be calculated by a so-called clone counting method of integrating the current.

As described above, in the battery system 1 of the present embodiment, the communication between the battery packs is performed by the producer-consumer method. Therefore, timings at which the slave battery packs SP1 and SP2 transmit the battery state information SOX to the master battery pack MP are individually set without depending on each other between the slave battery packs SP1 and SP2.

For example, when the timing to transmit the battery state information SOX is set every 500 ms in the slave battery packs SP1 and SP2, the control unit 20 of the slave battery pack SP1 waits until 500 ms elapses from a previous transmission timing (Step S18: NO). When 500 ms has elapsed from the previous transmission timing (Step S18: YES), the control unit 20 transmits the battery state information SOX recorded in the buffer memory 24 in Step S16 to the master battery pack MP regardless of the transmission timing of the slave battery pack SP2 (Step S20).

On the other hand, similarly to the control unit 20 of the slave battery pack SP, the control unit 20A of the master battery pack MP sequentially records in the buffer memory 24A the digital values (voltage data, current data, and temperature data) of the voltage, the current, and the temperature based on the detection value of each sensor in the master battery pack MP. The sampling interval of the detection values of each sensor is not limited, but is, for example, around 10 ms.

In Fig. 5, when the control unit 20A of the master battery pack MP of the present embodiment has reached the reading timing of the voltage, the current, and the temperature of its own battery module 10 (Step S30: YES), the control unit 20A reads the voltage data, the current data, and the temperature data from the buffer memory 24A (Step S32). The reading timing is not limited, but is, for example, every 100 ms. Next, the control unit 20A calculates the battery state information SOX such as SOC and SOP based on the read voltage data, current data, and temperature data (Step S34) and records it in the buffer memory 24A (Step S36). Note that the voltage data, the current data, the temperature data, and the calculated battery state information SOX such as SOC and SOP may be recorded not in the buffer memory 24A but in a RAM (not shown).

Although not shown in Fig. 5, the control unit 20A of the master battery pack MP receives a data frame including an ID indicating that the slave battery pack (that is, any one of the battery packs 3-2 and 3-3) is the transmitting node from the battery system CAN bus 200. Then, the control unit 20A records the battery state information SOX included in the data frame in the buffer memory 24A in association with the battery pack as a transmission source. That is, the master battery pack MP sequentially receives the data frame including the battery state information SOX of each slave battery pack SP according to the transmission timing of the battery state information SOX set in each slave battery pack SP, and records the battery state information SOX in the buffer memory 24A in association with the battery pack as the transmission source.

Note that an interval of the transmission timing set in the slave battery pack SP is shorter than an interval of a calculation timing of integrated battery information IBD described later. Therefore, until the calculation timing of the integrated battery information IBD is reached, the battery state information SOX of the slave battery pack SP is sequentially overwritten in the buffer memory 24A.

As described above, the control unit 20A of the master battery pack MP calculates the battery state information SOX of its own battery module 10 at a predetermined timing and records it in a RAM (RANDOM ACCESS MEMORY, not shown) or the buffer memory 24A. At the same time, the control unit 20A acquires the battery state information SOX of the battery module 10 of each slave battery pack SP via the battery system CAN bus 200 and records it in the buffer memory 24A.

When a predetermined calculation timing of the integrated battery information (hereinafter, appropriately referred to as "IBD") is reached (Step S38: YES), the control unit 20A reads the battery state information SOX of its own and of each slave battery pack SP from the buffer memory 24A (Step S40), and calculates the integrated battery information IBD (Step S42).

When the calculation timing of the integrated battery information IBD is not reached (Step S38: NO), the operation returns to Step S30. That is, the control unit 20A of the master battery pack MP calculates its own battery state information SOX and sequentially overwrites it in the buffer memory 24A during the interval of the calculation timing of the integrated battery information IBD. Further, the control unit 20A sequentially records and overwrites the battery state information SOX received from each slave battery pack SP in the buffer memory 24A before reaching the calculation timing of the integrated battery information IBD. Therefore, in Step S42, the integrated battery information IBD is calculated based on the latest battery state information SOX of the battery module 10 of the master battery pack MP and each slave battery pack SP.

After calculating the integrated battery information IBD, the control unit 20A controls the CAN transceiver and generates a data frame including the calculated integrated battery information IBD. Then, the control unit 20A sends it out to the vehicle system CAN bus 100. That is, the control unit 20A transmits the integrated battery information IBD to the vehicle control unit (VCU) 2 (Step S44). The vehicle control unit (VCU) 2 can display the integrated battery information IBD using a meter or the like, use the IBD for control of limiting discharge at an end of the discharge, or use the IBD for timing to stop the discharge in order to inform a battery state to a user of the electric vehicle.

Fig. 6 shows timings from transmission of the battery state information SOX by each slave battery pack SP to reception of the integrated battery information IBD by the vehicle control unit 2. In Fig. 6, (a) shows a timing when the slave battery pack SP1 transmits the battery state information SOX, (b) shows a timing when the slave battery pack SP2 transmits the battery state information SOX, (c) shows a timing when the buffer memory 24A is updated in the master battery pack MP, (d) shows a timing when the master battery pack MP calculates the integrated battery information IBD and transmits it to the vehicle control unit 2, and (e) shows a timing when the vehicle control unit 2 receives the integrated battery information IBD.

As shown in Figs. 6(a) and 6(b), in the slave battery packs SP1 and SP2, the transmission timing of the battery state information SOX is preset. In Figs. 6(a) and 6(b), an example is shown in which the interval of the transmission timing is the same for the slave battery packs SP1 and SP2, and the transmission timings are alternately set, but is not limited thereto. The transmission timing from each slave battery pack SP can be arbitrarily set, and even if the transmission timings overlap, the communication mediation defined by a CAN protocol is performed based on the ID in the data frame.

As shown in FIG. 6 (c), when the data frame is sent out from the slave battery packs SP1 and SP2 to the battery system CAN bus 200, the master battery pack MP recognizes that the transmitting node is the slave battery pack based on the ID included in the data frame, and receives the data frame. Then, the master battery pack MP associates the battery state information SOX included in the data frame with the slave battery pack (any one of the battery packs 3-2 and 3-3) of the transmission source and updates the buffer memory 24A.

The update processing of the buffer memory 24A is performed independently (that is, in parallel) with other processes (for example, a calculation process of the integrated battery information IBD shown in Fig. 6 (d)) in the control unit 20A. Therefore, for example, it is not necessary to wait until the update processing of the buffer memory 24A is completed in order to perform the calculation and transmission process of the integrated battery information IBD. Note that such a parallel processing can be easily realized by incorporating a DMA (Direct Memory Access) control unit in the microcontroller in the control unit 20A.

In the master battery pack MP, a timing when the calculated integrated battery information IBD is transmitted is predetermined. At this timing, as shown in Fig. 6 (d), the latest battery state information SOX of its own and of the slave battery packs SP1 and SP2 is read from the buffer memory 24A. Then, the integrated battery information IBD is calculated. Next, the master battery pack MP generates a data field containing a data field containing the calculated integrated battery information IBD, and the ID for identifying the master battery pack MP (battery pack 3-1) which is the transmitting node, and sends it out to the vehicle system CAN bus 100.

As shown in Fig. 6 (c), the buffer memory 24A of the master battery pack MP is sequentially updated. Therefore, the calculation and transmission timing of the integrated battery information IBD of Fig. 6 (d) can be set to an arbitrary timing.

As shown in Fig. 6 (e), the vehicle control unit 2 sequentially receives the data frames sent from the master battery pack MP to the vehicle system CAN bus 100.

As described above, the battery system 1 of the present embodiment has the plurality of battery packs 3-1 to 3-3 connected in parallel to the load L. Each of the plurality of battery packs includes the battery module 10. Further, the plurality of battery packs is set as either the master battery pack or the slave battery pack. The slave battery packs SP1 and SP2 detect the voltage, the current, and the temperature of the battery module 10, calculate the battery state information SOX of the battery module 10, and transmit the calculated battery state information SOX to the master battery pack MP. The master battery pack MP calculates the integrated battery information IBD of the plurality of battery packs based on the battery state information SOX calculated by itself and the battery state information SOX received from each of the slave battery packs SP1 and SP2.

That is, the slave battery pack SP transmits the detected voltage, current, and temperature values of the battery module 10 to the master battery pack MP. Therefore, the master battery pack MP does not calculate the battery state information SOX of each battery pack. Instead, each battery pack calculates its own battery state information SOX in the battery system 1 of the present embodiment. Therefore, a processing load for calculating the battery state information SOX of all the battery packs does not concentrate on the master battery pack MP. This processing load is distributed to the plurality of battery packs in the system. Therefore, the calculated battery state information is transmitted from the slave battery pack. Therefore, a communication volume is reduced. As a result, expandability of the battery system 1 can be improved.

Furthermore, in the battery system 1 of the present embodiment, the communication between the battery packs is performed by the producer-consumer method. That is, when each slave battery pack SP transmits the battery state information SOX to the master battery pack MP, each slave battery pack SP does not receive a transmission request from the master battery pack MP. Instead, the battery state information SOX is transmitted at the preset timing in each slave battery pack SP. This contributes to an increase in the number of battery packs which can be accommodated in the battery system 1. The reason will be described below.

If the communication between the master battery pack MP and each slave battery pack SP is performed by the polling method, a processing time from when the master battery pack MP makes the transmission request to the slave battery pack SP until the data is received is required as many as the number of the slave battery packs SP. Thus, as the number of the slave battery packs SP increases, a communication time for receiving the battery state information SOX of all the slave battery packs SP becomes longer. Therefore, it is forced to lengthen an interval when transmitting the integrated battery information IBD to the vehicle control unit 2 as the number of slave battery packs SP increases.

In contrast, in the present embodiment, the transmission request from the master battery pack MP to each slave battery pack SP is not necessary. The battery system of the present embodiment has a configuration in which the master battery pack MP sequentially receives the data of the battery state information SOX sent to the bus from each slave battery pack SP at an individual timing. Therefore, even when the number of slave battery packs SP increases, it is possible to suppress an increase in a time required to receive the battery state information SOX of all the slave battery packs SP. Further, the calculation of the battery state information SOX of the battery pack is distributed to the plurality of battery packs in the system. Therefore, the load of the master battery pack is reduced. As a result, a processing speed also increases. Therefore, it is possible to increase the number of battery packs which can be accommodated in the battery system 1. That is, the expandability of the battery system 1 can be improved.

Further, in the battery system 1 of the present embodiment, the calculation of the battery state information SOX of the battery pack is distributed to the plurality of battery packs in the system. Furthermore, when each slave battery pack SP transmits the battery state information SOX to the master battery pack MP, each slave battery pack SP does not receive the transmission request from the master battery pack MP. Instead, the battery state information SOX is transmitted at the preset timing in each slave battery pack SP. Therefore, a function of the master battery pack can be reduced. Thus, the system controller which controls the entire battery pack can be integrated into any one of the plurality of battery packs. Therefore, it is possible to reduce a space in the electric vehicle in which the system controller is disposed, and to reduce the cost.

Further, in the battery system 1 of the present embodiment, the master battery pack MP collects information such as the voltage and the temperature of its own battery module 10, collects information on the battery module 10 of the slave battery pack SP, and calculates the integrated battery information IBD based on them. Therefore, the cost can be reduced as compared with a case where the system controller which controls the whole of the plurality of battery packs is separated from the plurality of battery packs.

Further, in the battery system 1 of the present embodiment, since the processing load is distributed to the plurality of packs as described above, it is possible to reduce the processing load of the master battery pack MP. Therefore, it is possible to reduce the cost associated with data processing. Further, as described above, even when the number of slave battery packs SP increases, it is possible to suppress an increase in the time required to receive the battery state information SOX of all the slave battery packs SP. Therefore, it is possible to reduce the cost associated with the data processing.

One embodiment of the battery system of the present invention has been described above in detail. However, the battery system of the present invention is not limited to the above embodiment. Further, various improvements and modifications can be made to the above-described embodiment within a scope not deviating from the gist of the present invention.

For example, as long as the slave battery pack transmits the battery state information without receiving a transmission request from the master battery pack, a communication method between the master battery pack and the slave battery pack is not limited to a specific communication method. It is also possible to adopt a communication method other than the producer-consumer method.

In the above-described embodiment, the battery system of the present invention applied to the electric vehicle is described. However, the battery system of the present invention is not limited to this embodiment. The battery system of the present invention may be applied to an equipment other than the vehicle. Even in that case, it goes without saying that a merit can be obtained in which the expandability of the system can be improved by a space-saving property that a space for storing the system controller independent from the battery pack is not necessary and by increasing the number of connected battery packs.

The transmission timing of the battery state information of each slave battery pack may be changed within a range where the system can be established according to the type of the battery state information. For example, a transmission frequency of SOH may be lower than the transmission frequency of any one of SOC, SOP, and the internal resistance. Further, the transmission timing of the battery state information by the slave battery pack may be variable depending on the situation. For example, the transmission timing of the battery state information may not be the timing at every fixed interval. That is, the transmission timing may be an irregular timing (for example, when a calculation result of the estimated value of SOC or the like is obtained). Further, the interval of the transmission timing of each slave battery pack may be different from each other.

Each of the slave battery packs may individually determine the transmission timing of the battery state information. In that case, each slave battery pack may have an irregular transmission timing.

As is apparent from the above embodiment and its modifications, a problem of concentration of the load on the system controller, which occurs when the battery pack is added, can be solved by distributing the function of the system controller to each battery pack. Further, an increase in the communication volume between the system controller and the battery pack can be solved by distributing the function and by transmitting them at the timing of the battery pack itself. Furthermore, securing a space due to the separate system controller can be solved by reducing the load on the system controller by a distribution of the function to each battery pack. That is, since the load of the system controller is reduced, the function of the system controller can be integrated in the master controller without increasing the cost.

### LIST OF REFERENCE NUMERALS

- 1:: Battery system
- 2:: Vehicle control unit (VCU)
- 3-1 to 3-3:: Battery pack
- 4:: 12 V battery
- 5:: Ignition switch
- 6, 7:: Main relay
- 10:: battery module
- 10-1 to 10-8:: Battery cell
- 100:: Vehicle system CAN bus
- 200:: Battery system CAN bus
- SP1, SP2 (SP):: Slave battery pack
- MP:: Master battery pack
- 10:: Battery
- 20, 20A:: Control unit (CU)
- 22:: Voltage sensor
- 24, 24A:: Buffer memory
- 32:: Temperature sensor
- 34:: Current sensor
- 36, 38:: Relay
- L:: Load

## Claims

1. A battery system comprising a plurality of battery packs, wherein
each of the plurality of battery packs comprises: one or a plurality of batteries; an acquiring unit that acquires physical quantities of the one or the plurality of batteries; a calculation unit that calculates battery state information which is information on a state of the one or the plurality of batteries based on the acquired physical quantities; and a communication unit that communicates with another battery pack,
any battery pack of the plurality of battery packs is set as a master battery pack and a battery pack other than the master battery pack is set as a slave battery pack, and
the slave battery pack transmits the calculated battery state information to the master battery pack, and the master battery pack calculates integrated battery information which is integrated information of the plurality of battery packs based on each battery state information of the plurality of battery packs.

2. The battery system according to claim 1, wherein the slave battery pack transmits the battery state information at a preset timing instead of receiving a transmission request from the master battery pack.

3. The battery system according to claim 1 or 2, wherein
the physical quantities of the battery are at least voltage between terminals of the one or the plurality of batteries and current flowing through the one or the plurality of batteries, and
the battery state information is at least one of SOC (State Of Charge), SOP (State Of Power), SOH (State Of Health), and an internal resistance of the battery.
